# EUROPÄISCHE PATENTANMELDUNG

(11) **EP 2 234 156 A2**
(43) Veröffentlichungstag der Anmeldung: **29.09.2010**
(21) Anmeldenummer: 10002042.9
(22) Anmeldetag: 01.03.2010
(51) Int. Cl.: H01L 23/495

(54) **Leistungsmodul und Verfahren zum Herstellen eines für Hochvoltanwendungen geeigneten festen Leistungsmoduls**

(30) Priorität: 28.03.2009 DE 102009014794
(71) Anmelder: Danfoss Silicon Power GmbH, 24837 Schleswig (DE)
(72) Erfinder: Kock, Mathias, 25557 Gockels (DE); Senyildiz, Teoman, 24837 Schleswig (DE); Eisele, Ronald, Prof. Dr., 24229 Surendorf (DE)
(74) Vertreter: Biehl, Christian

(57) **Zusammenfassung**

Leistungsmodul und Verfahren zum Herstellen eines festen Leistungsmoduls mit einer elektrisch isolierenden und thermisch gut leitenden, als Beschichtung aufgetragenen Schicht, wobei der Aufbau aufgespritzte, miteinander verschmolzene Partikel wenigstens eines elektrisch isolierenden, thermisch gut leitenden Materials aufweist, erzeugt mit den Verfahrensschritten :
- Erzeugen eines einstückig Stanzgitters,
- Bestücken des Stanzgitters mit Halbleiterbausteinen, etwaigen passiven Bauelementen und Bonden entsprechender Verbindungen,
- Einbringen des derart bestückten Stanzgitters in ein Presswerkzeug, so daß eine Zugänglichkeit von Teilbereichen des Stanzgitters gewährleistet ist,
- Einpressen einer duroplastischen Pressformmasse in das Werkzeug unter Umhüllung des bestückten Stanzgitters, und
- Beschichten des derart bestückten Stanzgitters in wenigstens den elektrisch leitenden und überlappend auch den überwiegenden Flächen der mit Mouldmasse gefüllten Zwischenräume der Unterseite durch thermisches Spritzen.

## Beschreibung

Die Erfindung betrifft ein Leistungsmodul und ein Verfahren zum Herstellen eines für Hochvoltanwendungen geeigneten festen Leistungsmoduls.

Bisher werden Leistungshalbleitermodule typischerweise durch mehrfache Übergänge aus Lot, Kleber, NTV (Niedertemperaturverbindung) oder eine dauerflexible Paste (Wärmeleitpaste) gebildet, die die verschiedenen Teilelemente Kühlkörper, Wärmesenke (Bodenplatte), Substrat und Halbleiter miteinander verbinden. Dabei müssen zunächst die Halbleiter auf das Substrat aufgelötet werden, das zumeist aus mehreren Schichten (isolierenden und metallischen) besteht, das Substrat wiederum auf eine metallische Wärmesenke aufgelötet werden, die thermisch (und meist auch elektrisch) gut leitend die Wärmespreize darstellt und schließlich diese Wärmespreize mit einem Kühlkörper verbunden werden.

Wichtig ist, daß die hohen Ströme oder elektrischen Spannungen, mit denen die Leistungshalbleiter betrieben werden, nicht an den Kühlkörper gelangen können.

Es ist daher wichtig, eine sichere elektrische Isolierung zu schaffen, dennoch einen guten Wärmeübergang zu gewährleisten. Üblicherweise wird daher das Substrat als Dickschichtkeramik, DCB oder dergleichen aufgebaut, bei der ein keramischer Kern, z. B. Al₂O₃ oder A1N oder dergleichen als Isolator mit guter Wärmeleitung mit zwei strukturierten elektrisch leitenden Schichten versehen ist, die z. B. aus Kupfer oder aus Dickschichtpasten bestehen.

Problematisch bei einem derartigen Aufbau ist, dass die erheblichen Wärmemengen durch einen oder mehrere Übergänge aus Lot oder Kleber geleitet werden, die durch Alterung verspröden, wobei der Wärmefluss dann durch entsprechend geringere Querschnitte geleitet werden muss, die dann um so schneller altem.

Feste Leistungsmodule werden durch Kapselung vor einigen Einflüssen der Zeit und der Alterung geschützt. Beispielsweise ist aus der DE 10 2007 020 618 B3 der Anmelderin bereits ein Verfahren zum Herstellen eines festen Leistungsmoduls bekannt, bei dem mit Hilfe eines Presswerkzeuges ein Stanzgitter (durch Fixationsstempel im Presswerkzeug fixiert) im bestückten Zustand mit einer Mouldmasse umgeben wird, wobei beim Umhüllen Ausnehmungen an vorbestimmten Positionen verbleiben und ein nachfolgendes Heraustrennen von Stegen des Stanzgitters durch den in den Ausnehmungen eingeführten Stanzstempel möglich ist.

Weiter ist aus der DE 2004 005 534 A1 der Anmelderin bereits ein Leistungshalbleitermodul bekannt, dessen Aufbau mit einer aufgespritzten Schicht aus miteinander verschmolzenen Partikeln als mit dieser Schicht innig verbundene elektrische leitende Verdrahtungsebene auf der ausgespritzten Schicht vorgesehen bekannt ist. Bei diesem Modul wird ein festes Keramiksubstrat durch eine Metallisierung ersetzt. Es wird also eine Lösung lediglich für das Innere eines Moduls angestrebt.

Mit der vorliegenden Erfindung soll nun ein festes Leistungsmodul, wie für Kraftfahrzeuganwendungen, insbesondere bei Hybridfahrzeugen, mit der notwendigen stoffschlüssigen Anbindung an den Modulkörper versehen und zwar in thermisch leitfähiger, elektrisch isolierender, aber insbesondere auch in wasserfester und wasserdichter Weise ermöglicht werden.

Bei den oben beschriebenen Modulen des Standes der Technik bestand ein Problem in der erreichbaren Isolationsfestigkeit, d. h. in ihrer Spannungsklasse.

Die Stanzgitterelemente, die zum Kühlkörper freiliegen, sind bei den oben beschriebenen Verfahren potentialbehaftet und müssen daher gegeneinander und gegenüber dem Kühlkörper elektrisch isoliert werden.

Hierzu ist im Stand der Technik eine isolierende Paste oder eine isolierende Folie zwischen Modulkörper mit den Stanzgitterelementen und dem Kühlkörper platziert. Stanzgitterelemente sind typischerweise ca. 0,5 mm voneinander entfernt.

Typische Wärmeleitfolien (wie Keratherm Red^{®}) weisen eine Spannungsfestigkeit von ca. 4000 V/mm auf. Diese Spannungsfestigkeit ist jedoch nicht anwendbar, wenn keine stoffliche Verbindung zwischen Modul bzw. Stanzgitterelement vorliegt. In diesem ist die Spannungsfestigkeit der Kriechstrecke zwischen den Stanzgitterelementen anzusetzen und diese beträgt für 0,5 mm ein einem inhomogenen elektrischen Feld lediglich ca. 250 V (nach DIN EN 60664-1). Eine Paste aber hat keine stoffliche Verbindung mit dem Mouldkörper und Stanzgitter. Daher ist der Wert der Kriechstrecke anzunehmen.

Für beide Fälle, Pasten und Folien, besteht der Nachteil also daran, dass bestenfalls eine formschlüssige Anpassung zu erreichen ist. Dies erweitert die Spannungsfestigkeit nicht wie gewünscht.

Weiter ist die elektrische Isolation der Stanzgitterelemente gegenüber dem Kühlkörper ist durch geeignete Materialien (z. B. Kaptonfolie) durchaus erzielbar, allerdings sind dann die ebenfalls erforderlichen Wärmeleitfähigkeiten nicht gegeben.

Pasten besitzen darüber hinaus technischen Nachteil, dass unter Montageandruck ein lebenslanges Fließen entlang der glatten Oberflächen von Modul und Kühlkörper stattfindet. Bei Temperaturwechselbelastung führt die Modulverformung sogar zum Hinauspumpen der Paste aus dem Spalt zwischen Modul und Kühlkörper (dem s.g. pump-out Effekt). Nachteil beider nach dem Stand der Technik benutzten Möglichkeiten ist daher eine ständige Verschlechterung des Wärmewiderstands zum Kühlkörper über die Zeit.

Schließlich hat sich als nachteilig erwiesen, dass die thermischen Eigenschaften von Pasten und Folien selbst bei Spezialmaterialien auf ca. 0,5 bis 5 W/mK limitiert sind. Damit sind also nur geringe Wärmeflüsse möglich bzw. der Halbleiter wird von einer hohen Betriebstemperatur geschädigt.

Der Erfindung liegt daher die Aufgabe zugrunde, ein Leistungsmodul zu schaffen, das diese Nachteile nicht aufweist.

Erfindungsgemäß wird dies durch ein Verfahren mit den Merkmalen des Hauptanspruches gelöst. Dabei wird weiter ermöglicht, dass auf einem Stanzgitter entsprechende Halbleiter beidseitig thermisch und elektrisch mittels Löten, Kleben, Sintern, Drahtbonden, usw. angesetzt werden, die anschließend in einem Transfer Mould Prozess umgespritzt werden, so dass auf der Seite zum Kühlkörper die Stanzgitterelemente frei liegen.

Zur elektrischen Isolierung wird nun diese Stanzgitterseite in einem zusätzlichen Schritt mit einer elektrisch isolierenden und thermisch gut leitenden Schicht mittels thermischen Spritzen beschichtet und somit für Hochvoltanwendungen tauglich gemacht.

Mit den Merkmalen des Hauptanspruches gelingt es also, durch eine stoffschlüssige Anbindung an den Modulkörper einerseits und durch gut wärmeleitende, elektrische Isolation den Kühlkörper andererseits thermisch anzubinden.

Weitere Merkmale und Vorteile der Erfindung ergeben sich aus nachfolgender Beschreibung eines bevorzugten Ausführungsbeispieles.

### Dabei zeigt:

- Fig. 1: den erfindungsgemäßen neuen Aufbau der sich von dem Stand der Technik durch eine zusätzliche Keramikisolationsschicht unterscheidet,
- Fig. 2: einen herkömmlichen Aufbau nach dem Stand der Technik, und
- Fig. 3: einen Aufbau wie Fig. 1 mit einer zusätzlichen, unter der Keramikisolationsschicht angespritzten Metallschicht.

Die in der Zeichnung dargestellte Unterseite der Module werden mit einer elektrisch isolierenden und thermisch gut leitenden Schicht z. B. einer oxidischen, nitridischen oder carbidischen Keramikschicht (Aluminiumoxid, Aluminiumnitrid oder Siliziumcarbit) beschichtet. Diese Beschichtungsmaterialien, wie auch schon in der genannten DE 10 2004 005 534 A1 aufgeführt, werden vorzugsweise durch thermisches Spritzen aufgebracht, wobei die Schichtdicke des Isolators abhängig ist von der gewünschten Isolationsfestigkeit und den Eigenschaften der gewählten Keramik oder des Keramikverbundes.

Durch ein Verklammern mit den rauen Flächen, insbesondere ihrer Spitzenrauhigkeiten gegeneinander wird ein Verkriechen gegeneinander und jede Form des pump-out Effektes verhindert, wobei auch die Wärmeleitpaste und eine Wärmeleitfolie sich in den Rauhigkeiten gut verklammert..

Damit kann eine Paste nicht mehr, durch die thermomechanische Bewegung des Moduls heraus gepresst werden. Die raue Oberfläche der gespritzten Keramikschicht 5 bietet eine flächige Verteilung von Restspalten und Kapillaren, die nicht auf Null-Abstand zusammengepresst werden können und somit durch Wärmeleitpasten vollständig und dauerhaft gefüllt bleiben.

### Bevorzugtes Ausführungsbeispiel 1:

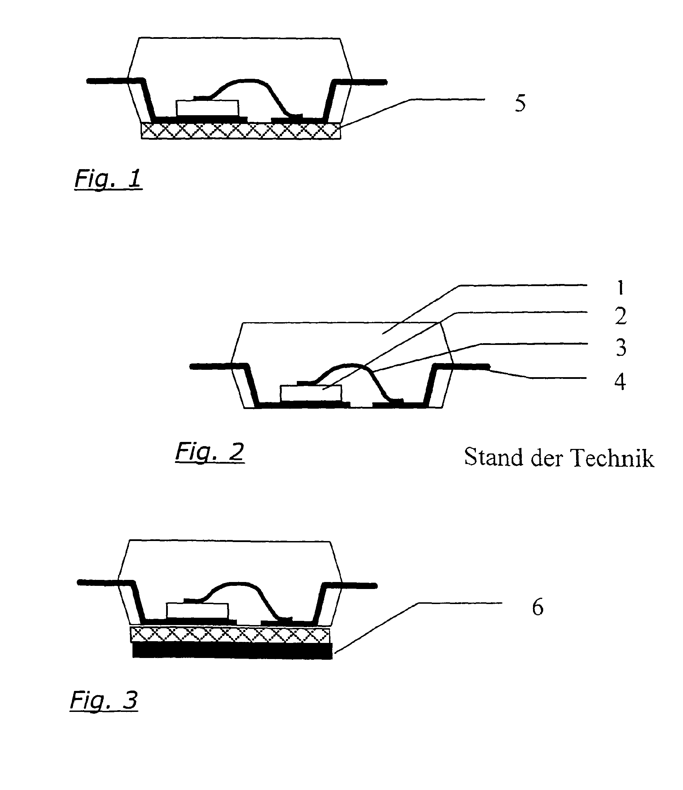

Bei einem bevorzugten Ausführungsbeispiel, wie es in der Fig. 1 im fertigen Zustand zu erkennen ist, wird ein Mouldmodul mit freiliegenden Stanzgitterbahnen 4 mit einer Schicht von Aluminiumoxid in der Dicke von ca 300µm durch thermisches Spritzen stoffschlüssig beschichtet. Eine solche gespritzte Schicht ist isolationsfest bis ca. 6000 V.

Diese Schichten besitzen eine thermische Leitfähigkeit von ca. 24 W/mK und sind damit deutlich wärmeleitfähiger als eine Paste oder Folie.

Gleichzeitig findet durch die stoffschlüssige Verbindung des Aluminiumoxids auf dem Kupfer des Stanzgitters 4 und dem Kunststoff des Modulkörpers 1 eine stoffschlüssige Verbindung mit der gespritzten Keramik statt.

Die Isolierfähigkeit zwischen Stanzgitterbahnen steigt beim Abstand von 0,5 mm auf 10 000 V. Damit ist ein Einsatz in Netzspannungsanwendungen möglich, bei denen die geforderte Mindestspannungsfestigkeit >2500V beträgt.

### Bevorzugtes Ausführungsbeispiel 2:

In einem weiteren Ausführungsbeispiel (Fig. 3) kann ein Mouldmodul mit freiliegenden Stanzgitterbahnen 4 neben einer Schicht 5 von Aluminiumoxid in der Dicke von ca. 300µm durch thermisches Spritzen auch stoffschlüssig mit einer weiteren Metallschicht beschichtet werden.

Die mindestens eine weitere Metallschicht aus z.B. Al, Ag, Cu wird durch z.B. Kaltgasspritzen auf die Schicht von Aluminiumoxid aufgebracht. Damit ist das Mouldmodul mit einer Schichtenfolge Keramik-Metall in der Lage durch Löten oder Drucksintern stoffschlüssig eine Verbindung zu einem metallischen Kühlkörper 6 zu ermöglichen. In dieser bevorzugten Ausführungsform ist der Wärmefluss vom Modul zum Kühlkörper durch eine solche stoffschlüssige Verbindung vielfach besser als durch eine Pastenschicht und ist daher, falls anwendbar, vorzuziehen.

Mit Bezugszeichen 2 ist der Halbleiter, mit Bezugszeichen 3 der Drahtbond darauf bezeichnet. Ganz allgemein ist damit ein Leistungsmodul mit einer elektrisch isolierenden und thermisch gut leitenden als Beschichtung aufgetragenen Schicht geschaffen, wobei der Aufbau aufgespritzte, miteinander verschmolzene Partikel wenigstens eines elektrisch isolierenden, thermisch gut leitenden Materials aufweist, und einem einstückigen Stanzgitter, wobei das Stanzgitter mit Halbleiterbausteinen und/oder passiven Bauelementen versehen ist, das derart bestückte Stanzgitters mit einer duroplastischen Umhüllungsmasse umhüllt ist, und das bestückten Stanzgitter in wenigstens den elektrisch leitenden und überlappend auch den überwiegenden Flächen der mit Mouldmasse gefüllten Zwischenräume der Unterseite durch thermisches Spritzen beschichtet ist.

Bevorzugt wird ein Leistungsmodul bei dem der Aufbau aufgespritzte, miteinander verschmolzene Partikel aus Aluminiumoxid aufweist, und die thermisch gut leitende Schicht 5 aus Aluminiumoxid mit einer weiteren Metallschicht aus Al oder Ag durch Löten eine stoffschlüssige Verbindung zu einem Kühlkörper 6 aufweist.

Alternativ kann das Leistungsmodul im Aufbau aufgespritzte, miteinander verschmolzene Partikel aus Siliziumcarbid aufweisen, und die somit carbidische, elektrisch isolierende Schicht 5 eine thermische Leitfähigkeit von 24 W/mK aufweisen, wobei mit einer in den Restspalten und Kapillaren dauerhaft verbleibenden Wärmeleitpaste eine kriechfeste, formschlüssige Verbindung mit einem Kühlkörper 6 geschaffen ist.

## Patentansprüche

1. Leistungsmodul mit einer elektrisch isolierenden und thermisch gut leitenden als Beschichtung aufgetragenen Schicht, wobei der Aufbau aufgespritzte, miteinander verschmolzene Partikel wenigstens eines elektrisch isolierenden, thermisch gut leitenden Materials aufweist, und einem einstückigen Stanzgitter,
wobei das Stanzgitter mit Halbleiterbausteinen und/oder passiven Bauelementen versehen ist,
das derart bestückte Stanzgitters mit einer duroplastischen Umhüllungsmasse umhüllt ist, und
das bestückten Stanzgitter in wenigstens den elektrisch leitenden und überlappend auch den überwiegenden Flächen der mit Mouldmasse gefüllten Zwischenräume der Unterseite durch thermisches Spritzen beschichtet ist.

2. Leistungsmodul nach Anspruch 1, **dadurch gekennzeichnet, daß** der Aufbau aufgespritzte, miteinander verschmolzene Partikel aus Aluminiumoxid aufweist, und die Schicht (5) aus Aluminiumoxid mit einer weiteren Metallschicht aus Al oder Ag durch Löten eine stoffschlüssige Verbindung zu einem Kühlkörper (6) aufweist.

3. Leistungsmodul nach Anspruch 1, **dadurch gekennzeichnet, daß** der Aufbau aufgespritzte, miteinander verschmolzene Partikel aus Siliziumcarbid aufweist, und die carbidische, elektrisch isolierende Schicht (5) eine thermische Leitfähigkeit von 24 W/mK aufweist und mit einer in den Restspalten und Kapillaren dauerhaft verbleibenden Wärmeleitpaste zur kriechfesten formschlüssigen Verbindung mit einem Kühlkörper (6) versehen ist.

4. Leistungsmodul nach Anspruch 1, **dadurch gekennzeichnet, dass** die zusätzliche metallische Schicht auf eine raue Außenseite der isolierenden, thermisch gespritzten Schicht mit Kaltgasspritzen aufgetragen wird.

5. Verfahren zum Herstellen eines festen Leistungsmoduls mit einer elektrisch isolierenden und thermisch gut leitenden als Beschichtung aufgetragenen Schicht nach einem der vorangehenden Ansprüche, mit den Schritten :
- Erzeugen eines einstückigen Stanzgitters mit einem Stanzgitterbahnabstand von 0,5 mm oder mehr,
- Bestücken des Stanzgitters mit Halbleiterbausteinen, etwaigen passiven Bauelementen und Bonden entsprechender Verbindungen,
- Einbringen des derart bestückten Stanzgitters in ein Presswerkzeug, so daß eine Zugänglichkeit von Teilbereichen des Stanzgitters gewährleistet ist,
- Einpressen einer duroplastischen Pressformmasse in das Werkzeug unter Umhüllung des bestückten Stanzgitters, und
- Beschichten des derart bestückten Stanzgitters in wenigstens den elektrisch leitenden und überlappend auch den überwiegenden Flächen der mit Mouldmasse gefüllten Zwischenräume der Unterseite durch thermisches Spritzen in einer Dicke von 300 µm.

6. Verfahren nach Anspruch 5, **dadurch gekennzeichnet, dass** beim Beschichten eine elektrisch isolierende Aluminium enthaltende Substanz durch thermisches Spitzen aufgetragen wird.

7. Verfahren nach einem der vorangehenden Ansprüche, **dadurch gekennzeichnet, dass** die Substanz Aluminiumoxid enthält.

8. Verfahren nach einem der vorangehenden Ansprüche, **dadurch gekennzeichnet, dass** die Substanz Aluminiumnitrid enthält.

9. Verfahren nach einem der vorangehenden Ansprüche, **dadurch gekennzeichnet, dass** die Substanz Siliziumcarbid enthält.

10. Verfahren nach einem der vorangehenden Ansprüche, **dadurch gekennzeichnet, daß** die Schicht auf der freien Außenseite rau verbleibt.

11. Verfahren nach einem der vorangehenden Ansprüche, **dadurch gekennzeichnet, daß** die eine zusätzliche metallische Schicht auf der Außenseite der isolierenden, thermisch gespritzten Schicht aufgetragen wird.
